Europäisches Patentamt

European Patent Office

Office européen des brevets

(11) Publication number: **0 259 489 B1**

# EUROPEAN PATENT SPECIFICATION

(45) Date of publication of patent specification: **20.05.92**

(51) Int. Cl.⁵: **B23P 19/00**, B65G 25/12, H05K 13/00

(21) Application number: **85906081.6**

(22) Date of filing: **27.11.85**

(86) International application number:
**PCT/JP85/00655**

(87) International publication number:
**WO 87/03234 (04.06.87 87/12)**

(54) WORKING APPARATUS.

(43) Date of publication of application:
**16.03.88 Bulletin 88/11**

(45) Publication of the grant of the patent:
**20.05.92 Bulletin 92/21**

(84) Designated Contracting States:
**DE**

(56) References cited:
**EP-A- 0 010 131**     **EP-A- 0 076 231**
**DE-A- 2 717 035**     **JP-B-53 035 348**
**JP-B-57 036 101**     **US-A- 4 202 092**
**US-A- 4 231 153**

**WERKSTATTSTECHNIK, vol. 68, no. 11, November 1978, pages 681-685, Springer-Verlag; W. RÖSSNER: "Palettenfördersystem mit Linearmotorantrieb"**

(73) Proprietor: **MATSUSHITA ELECTRIC INDUSTRIAL CO., LTD.**
**1006, Oaza Kadoma**
**Kadoma-shi, Osaka-fu, 571(JP)**

(72) Inventor: **MARUYAMA, Masahiro**
**14-39, Hanjyo 2-chome**
**Minoo-shi Osaka-fu 562(JP)**
Inventor: **HATA, Kanji**
**6-8, Yamate 5-chome**
**Kisaichi, Katano-shi Osaka-fu 576(JP)**
Inventor: **ITEMADANI, Eiji**
**394-1, Minamihanada-cho**
**Sakai-shi Osaka-fu 591(JP)**
Inventor: **UCHIDA, Yoshihisa**
**652-25, Oaza Takanomiya**
**Neyagawa-shi Osaka 572(JP)**

(74) Representative: **Dr. Elisabeth Jung Dr. Jürgen Schirdewahn Dipl.-Ing. Claus Gernhardt**
**P.O. Box 40 14 68 Clemensstrasse 30**
**W-8000 München 40(DE)**

## Description

The present invention relates generally to a working apparatus provided with carriers which hold works on a working line and transport them, and with work heads which apply a predetermined operation at a predetermined position on the work transported into a work station on the working line.

A working apparatus of the type defined in the pre-characterising portion of Claim 1 is known from e.g. US-A-4202 092

Especially, the present invention is suitable to a working apparatus for automatically mounting electronic parts, such as a chip resistor or a chip laminated capacitor, on a substrate constituting an electronic circuit.

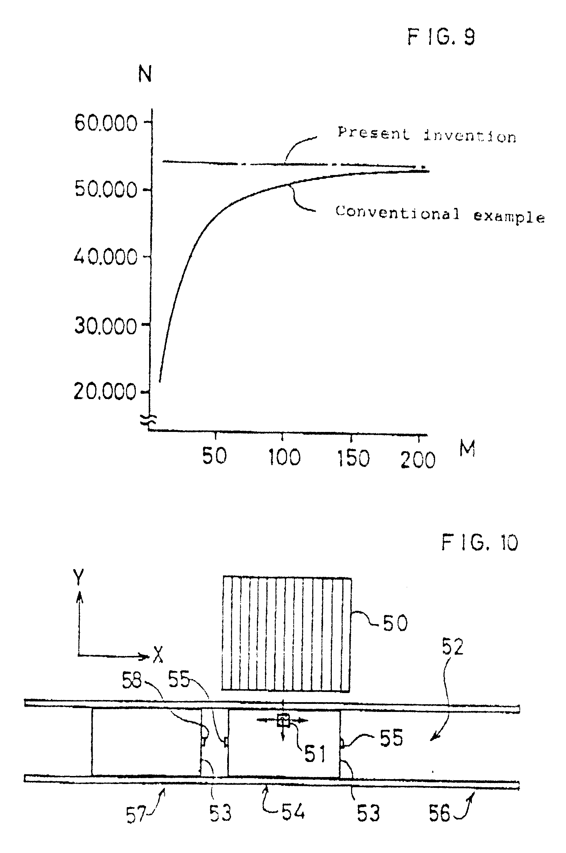

As a conventional working apparatus of this kind, there is one as shown in FIG. 10.

The conventional apparatus relates to an automatic part mounting apparatus which picks up by a work head 51 an electronic part disposed on a part feed unit 50 and transports it onto a work on a working line 52, concretely, onto a substrate 53, thereby mounting the electronic part on the predetermined position of the substrate 53. And the work head 51 moves in two horizontal directions X and Y so as to decide a point of operation for mounting the electronic part on the substrate 53.

On the other hand, the substrate 53 is adapted constructed so as to be positioned by a positioning means 5 in a predetermined stop position in a work area on the working line 52 to thereby be subjected to the mounting operation. The substrate 53 on which a necesssary number of electronic parts are mounted is discharged to a delivery position 56. Almost at the same time, the substrate 53 stand-by at a stand-by position 57 is transported to a work area 54 and the electronic part is mounted similarly on the substrate 53. In addition, reference numeral 58 designates a stopper for standing-by the substrate 53 on the stand-by position 57.

The aforesaid conventional apparatus takes a relatively much loading time to discharge the substrate 53 finished of its mounting operation from the working area 54 and charge a new substrate 53 therein, which requires relatively long time such as several seconds to about 5 seconds.

Accordingly, when the number of parts to be mounted on one substrate is small, a loss in the loading time seriously affects the work efficiency, to thereby largely decreases the work efficiency.

A graph in FIG. 9 takes on the axis of abscissa the number of parts mounted on one substrate and on the axis of ordinate the number of parts mounted for 400 minutes of operating time and shows by the solid line the curve of work efficiency of the conventional apparatus. The aforesaid problem can be apparently seen from this graph.

Furthermore, there is known from US-A-4 202 092 a working apparatus for applying predetermined operations on circuit boards. Plural circuit boards are supported on a common set of conveyor rails in one row with a constant interval and are displaced in X and Y coordinate directions while they are transferred from a feeding position to an unloading position. These circuit boards are transferred by hooks which are engaged with the holes thereof. These hooks are mounted on a feed shaft which is rotated by an air cylinder and are moved up and down at the ends of the hooks. Moreover the shaft is moved along the conveyor rail, and thereby the circuit boards are transferred. Plural part insertion heads are disposed above the circuit boards. After completion of the entire insertion operation, the shaft is rotated and the hooks are lowered. Thus the hooks are disengaged from the holes of the circuit boards. Subsequently, the shaft is moved to the feeding position and is rotated to rise the hooks. Thus new circuit boards are hooked with the hooks, and at the same time remaining circuit boards are also hooked. In this structure, since the shaft must be rotated and moved to the feeding position after completion of one circuit board, several seconds are needed thereto.

There is also known from US-A-4 231 153 an article placement system for applying a plurality of articles to a plurality of substrates arranged with a predetermined pitch on a stepwisely driven conveyor. A plurality of article supply members is mounted on the base of the article placement system. Since the substrates are arranged with a predetermined pitch, after completion of mounting the articles, the conveyor must be shifted by a distance corresponding to the pitch. Such shift of the conveyor takes several seconds. Said time becomes a loss time in the operation of that known article placement system.

It is the object of the present invention to provide a working apparatus of good working efficiency, which reduces a loading time of charging the work in the work area and discharging it therefrom, thereby theoretically enabling the loading time to be zero. Especially, the present invention aims at a remarkable improvement in the work efficiency at the working apparatus less in the working time per one work.

According to the invention there is provided a working apparatus comprising plural carriers for holding and moving works along a working line from a work feed position to a work station and to a work discharge position, and a movable work head for applying predetermined operations at predetermined positions on a work at the work station, characterized by head driving means for moving said work head in a direction different from the moving direction of the works and positioning said head in its said moving direction for a point of operation at a predetermined position on a work for each operation, and carrier driving means for each of said carriers for moving said carriers independently of each other along said working line from said work feed position to said work station and to said work discharge position, and back to said work feed position, and for positioning each carrier in its said moving direction for a point of operation at a predetermined position on the work at said work station for each operation said carriers being constituted not to interfere at the time of motion with other ones of said carriers and said works.

According to the present invention the carriers are driven independently from each other. Thus, when the assembly of a first work has been completed, the subsequent work, which is carried by the next carrier, closes to the first work, thereby reducing the idle time between the completion of the first work and the supply of the subsequent work.

The present invention has been designed to eliminate the defects of the conventional apparatuses and it is constructed as follows:

A work head 2 is constructed to apply the predetermined operation at the predetermined position on a work 1 and moves in a different direction from the moving direction of work 1 in the work area 3. The work 1 and the work head 2 may be moved in standard in perpendicular two directions on the horizontal plane, namely X and Y directions, as shown in the drawings, that is, the work 1 in the direction X and the work head 2 in the direction Y is the X-Y directions.

A head driving means 4 for moving the work head 2 and positioning the point of operation in the direction Y at every operation is provided.

Plural carriers are provided for holding the works 1 on the working line 5 and transporting them. In standard, two first and second carriers 6a and 6b may be provided as shown.

The carriers 6a and 6b are moved along the working line 5 sequentially toward the work feed position 7, work area 3 and work delivery position 8 in the order and restored therefrom toward the work feed position 7; and in order to position the print of operation in the direction X at the work area 3 at every operation, carrier driving means are provided corresponding to the carriers 6a and 6b respectively. Normally, a first carrier driving means 9a is provided to the first carrier 6a and a second carrier driving means 9b to the second carrier 6b.

Furthermore, the carriers 6a and 6b are constructed not to interfere, when restored, with other carriers 6b and 6a and work 1.

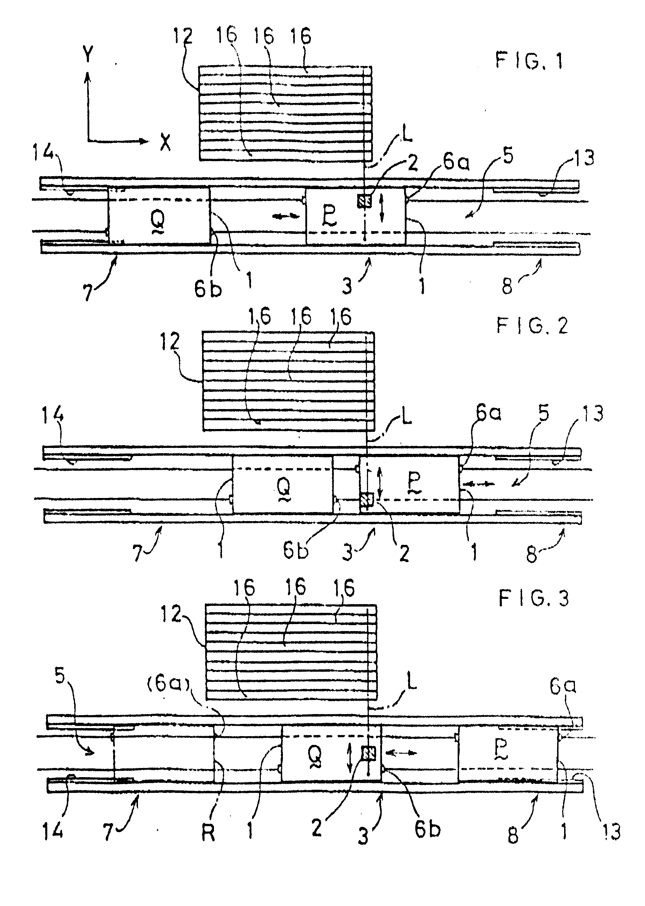

The present invention is further concretely constituted as shown by an embodiment of FIGs. 1 through 7, in which the respective carriers 6a and 6b move in reciprocation between the work feed position 7, the work area 3 and the work delivery position 8 and travel on the paths on which main bodies of carriers 6a and 6b do not interfere with each other, and work holders 11 at the carriers 6a and 6b change their postures not to interfere with the other carriers 6b and 6a and work 1.

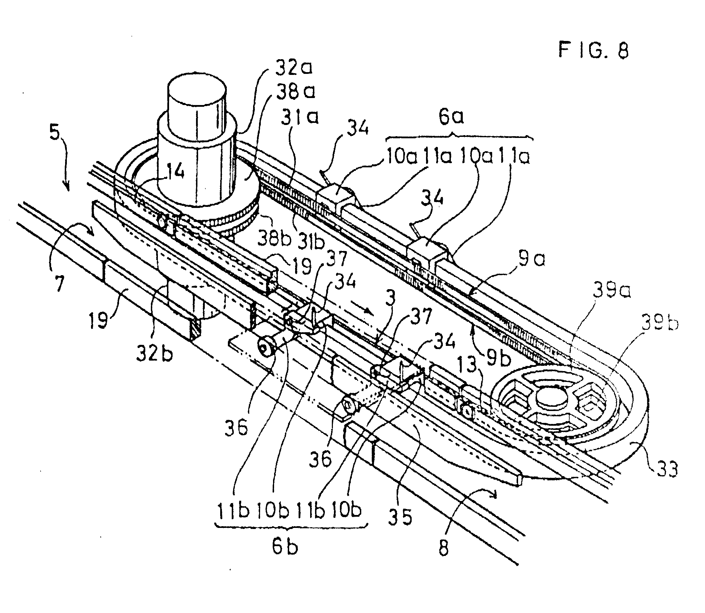

As a more concrete one constituted in a modified mode of the present invention, there is the one as shown in FIG. 8, in which the carriers 6a and 6b move on an endless path and in circulation between the work feed position 7, work area 3 and the work delivery position 8. In this case, carrier driving means 9a and 9b for driving the carriers 6a and 6b, respectively, are preferred to be composed of endless timing belts 31a and 31b independent of each other and pulse motors 32a and 32b.

The present invention being constructed as above-mentioned, for example, as shown in FIGs. 1 to 3, the first and the second carriers 6a and 6b can be moved each independently and accurate operations can be applied at the predetermined position of the X-Y coordinates of the work 1 positioned in the work area 3 and reduction in the loading time can be expected.

In FIG. 1, the work 1 designated by P is held to the first carrier 6a and positioned in the work area 3. The work head 2 functions to move in the direction Y, pick up a predetermined part from a part feed unit 12, transport the part to the work area 3, and mount the same on the predetermined position at work P. The work head 2 in the work area 3 carries out the mounting operation by positioning the point of operation in the direction Y, at which time the first carrier 6 is positioned at the point of operation in the direction X. Hence, the part mounting operation by the work head 2 is carried out at an accurate point of the coordinates X-Y of the work P.

On the work P a predetermined number of times of the mounting operations are carried out, and during it the work head 2 moves in reciprocation on a part transporting line L at every operation, and on the other hand the work P is gradually moved rightwardly in the drawing in an intermittent motion.

When the part mounting operation is carried out with respect to the work P, the work 1 designated by Q is held to the second carrier 6b at the work feed position 7 and then, as shown in FIG. 2, moves to a position close to the work P just before a finish of the part mounting operation of work P and is kept stand-by.

When the part mounting operation with respect to the work P finishes, the first carrier 6a moves toward the work delivery position 8 and places the work P on a discharge-side conveyor 13 through which the work P is transported outside the working line 5. Simultaneously, the work Q in stand-by condition is moved into the work area 3 by the second carrier 6b and subjected to the part mounting operation by the work head 2 as shown in FIG. 3.

During the while the work Q is being subjected to the part mounting operation, the first carrier 6a is moved restored from the work delivery position 8 to the work feed position 7 and receives the next work 1 which is designated by R and supplied by a feed side conveyor 14. Thereafter, the operation shown in FIGs. 1 to 3 is repeated.

The first carrier 6a, is constructed not to interfere with the second carrier 6b and work Q held thereto in its restoration motion, whereby the restoration motion can be made smooth. Similarly, the restoration motion second carrier 6b can be made smoothly, too.

Thus, according to the present invention, upon ending the operation of work 1 held by the first carrier 6a (or the second carrier 6b), a transferring to operation of the work 1 held to the second carrier 6b (or the first carrier 6a) can be made almost without the need of the loading time. Hence, as shown by the phantom line in a graph of FIG. 9, the work efficiency can ideally be kept in the best condition regardless the number of operations (in the example, the number of mounting parts) per one work 1.

## BRIEF DESCRIPTION OF DRAWINGS

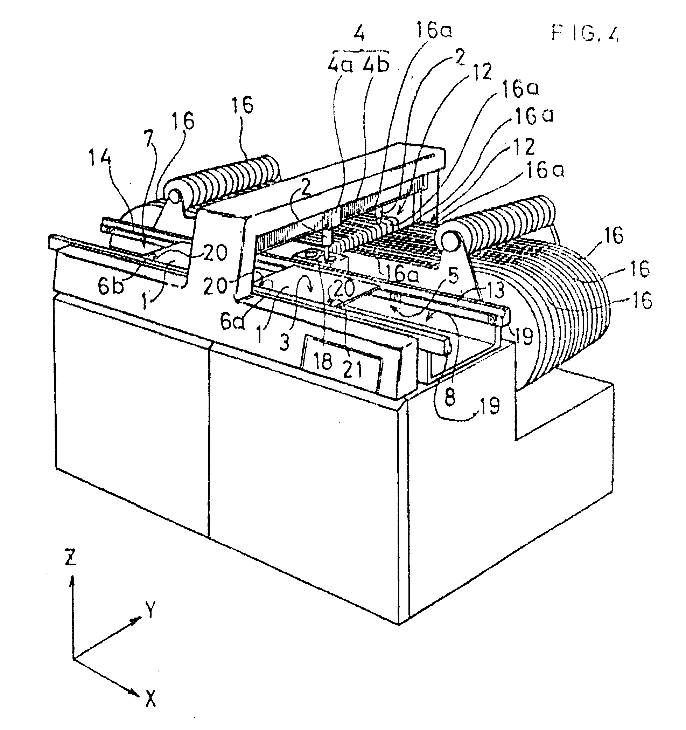

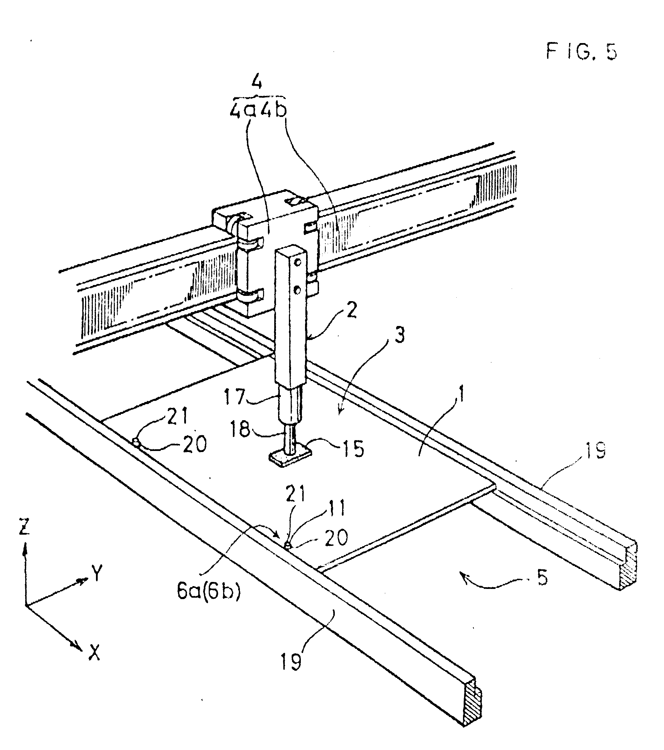

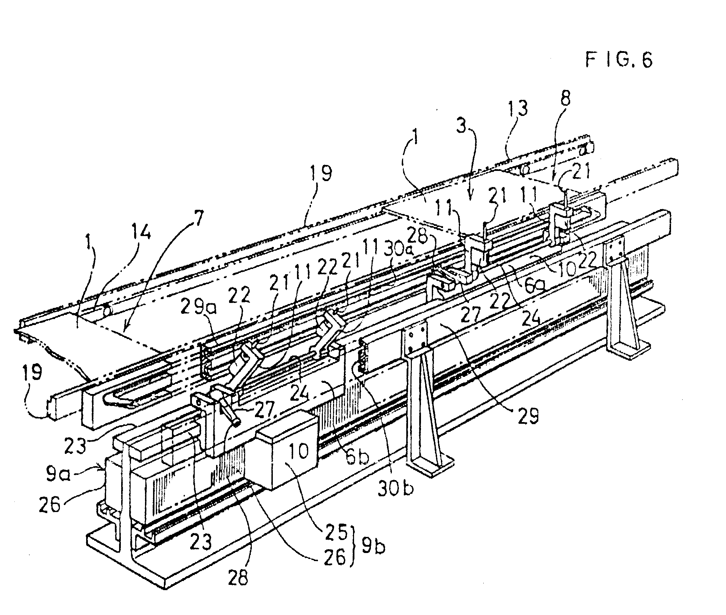

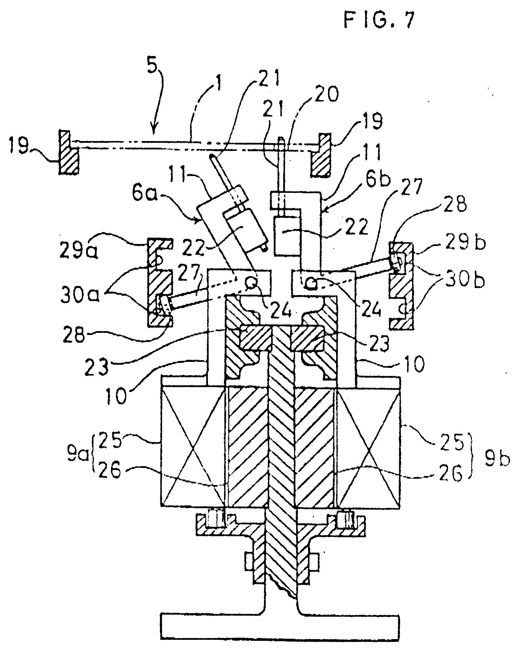

FIGs. 1, 2 and 3 are plan views of a first embodiment of a working apparatus of the invention, showing the principle and operation thereof, FIG. 4 is a perspective view of the entire first embodiment of the invention, FIG. 5 is a perspective view of a work head and a working line in part of the first embodiment, FIG. 6 is a perspective view of carriers and carrier driving means thereof, FIG. 7 is a longitudinal sectional view of the carriers and carrier driving means, FIG. 8 is a perspective view of carriers end carrier driving means at a second embodiment of the invention, FIG. 9 is the graph showing the work efficiency in comparison of the present invention with the conventional example, and FIG. 10 is the plan view of the conventional example in principle.

## BEST MODE FOR CARRYING OUT THE INVENTION

FIGs. 1 through 7 show a first embodiment of a working apparatus of the present invention. The first embodiment is an electronic part mounting apparatus for automatically mounting a large number of electronic parts (to be hereinafter called the parts) 15 (refer to FIG. 5) in order onto the predetermined positions on a substrate (to be hereinafter called the work).

This embodiment, as shown in FIG. 4, comprises two part feed units 12, 12 in laterally symmetrical with each other, two work heads 2, 2 corresponding to the part feed units 12, 12 respectively. Accordingly, a pair of head driving means 4, 4 are provided. When one work head 2 picks up a part 15 from the one part feed unit 12, the other work head 2 carries out the part mounting on the work area 3 on the working line 5 as exemplary in FIG. 4, so that both the work heads 2, 2 thus carry out basically the same motions and operations under such condition that the timings are different by a half cycle from each other, thereby improving the efficiency for the part mounting operation.

At each part feed unit 12 are disposed in parallel a large number of taping cassette units 16, each taping cassette 16a containing therein many parts 15 in alignment. The taping cassette 16a is transported intermittently in the direction X, so that one of the parts 15 reaching the pick-up position is picked up selectively by the work head 2 at every mounting operation. The parts at the pick-up position of each taping cassette 16a are nearly aligned on the part transporting line L (refer to FIG. 1).

Each work head 2 functions to pick up the part 15 from each part feed unit 12 and transport it onto the work area 3 on the working line 5, thereby mounting the part 15 at the predetermined position on the work 1 in the work area 3. And, the work head 2, so detailed in FIG. 5, comprises a head body 17 and a suction nozzle 18 movable vertically or in the direction Z with respect to the head body 17, the suction nozzle 18 using vacuum pressure to suck up the part 15 from the taping cassette 16a and pick up the same.

The head driving means 4, which controls the moving position of the work head 2 while being moved in the direction Y, is composed of, a linear pulse motor comprising a movable unit 4a provided integrally at the head body 17 and a fixed unit 4b serving as a guide rail therefor, and controls the moving position and the moving speed of the work head 2 in the direction Y on the basis of a pulse signal from a control device (not shown).

In addition, the suction nozzle 18 moves in the direction Z by driving means (not shown), such as an air cylinder, and also moves under control by the control device.

On the working line 5 extending in the direction X, as shown in FIGs. 4 through 7, are disposed a pair of guide rails 19, 19 for supporting and guiding the work 1, a feed side conveyor 14 for feeding the work 1, and a discharge side conveyor 13 for discharging the work 1 finished of part mounting operation at the work area 3. Also, on the working line 5 are disposed a pair of a first and a second carriers 6a and 6b. Also, as shown in FIGs. 6 and 7, a first carrier driving means 9a and a second carrier driving means 9b are provided which move the carriers 6a and 6b in the order toward the work feed position 7, work area 3 and work discharge position 8 along the working line 5 and further restore the same from the work discharge position 8 to the work feed position 7 and position the point of operation of each work 1 at the work area 3 at every operation.

Both the carriers 6a and 6b each comprise a retractive pin 21, a pair of work holders 11 provided with a solenoid 22 for projecting and retracting the retractive pin 21, and a carrier body 10 moving on a guide plate 23 in the direction X. Both carrier bodies 10, 10 move in reciprocation on the path so as not to interfere with each other. The retractive pins 21 detachably engages with a pair of engaging bores 20, respectively.

Each work holder 11 is supported swingably through a pivot shaft 24 rotatable together therewith to the carrier body 10. The pivot shaft 24 fixes a swinging lever 27 so that a guide roller 28 at the utmost end of the lever 7 is adapted to roll within each cam groove 30a or 30b provided at each cam plate 29a or 29b. The cam grooves 30a and 30b, as shown in FIG. 6, are loop-like-shaped.

The first and the second carrier driving means 9a and 9b each comprise a linear pulse motor comprising a movable unit 25 integral with the carrier body 10 and a plate-like fixed unit 26 extending in parallel with each other below the guide plate 23. The carrier driving means 9a and 9b move the first and the second carriers 6a and 6b independently in the direction X, position them, and control their moving speeds on the basis of the pulse signal from the control device, respectively.

The first carrier 6a, as shown in FIGs. 1 through 3, is driven by the first driving means 9a to move in the order of the work feed position 7, work area 3 and work delivery position 8. At that time, the work holder 11 at the first carrier 6a is upright, because the guide roller 28 at the swingable lever 27 is guided in the upper groove at the cam groove 30a of the cam plate 29a as shown in FIG. 6. When the feed side conveyor 14 transfers the work 1 to the first carrier 6a at the work feed position 7, the solenoid 22 operates to project the retractive pin 21 to engage with an engaging bore 20 at the work 1, thereby holding the work 1 to the first carrier 6a. The first carrier 6a is, in the work area 3, positioned at the point of operation in the direction X at every part mounting operation and the part mounting operation by the work head 2 positioned at the point of operation in the direction Y is applied to the work 1 held to the first carrier 6a, thereby mounting the part 15 at the predetermined points on the coordinates X-Y on the work 1. At the work delivery position 8, the solenoid 22 operates to retract the retractive pin 21 to disengage from the engaging bore 21, and thereafter, the work 1 on the first carrier 6a is transferred onto the discharge side conveyor 13. At this time, as shown in FIG. 7, the guide roller 28 at the first carrier 6a is guided in the lower groove at the cam groove 30a, whereby the work holder 11 is inclined. Hence, the first carrier 6a can be restored without interfering with the second carrier 6b and the work 1 supported thereby.

The second carrier 6b is driven, independently of the first carrier 6a, and is moved by the second carrier driving means 9b; basic function thereof being the same as the first carrier 6a, the elucidation thereof is omitted. The relation between the first carrier 6a and the second carrier 6b is as described in the Disclosure of Invention referring to FIGs. 1 through 3.

FIG. 8 shows a first carrier 6a, a second carrier 6b, a first carrier driving means 9a and a second carrier driving means 9b in a second embodiment of the working apparatus of the invention.

The first carrier driving means 9 comprises a first endless timing bolt 31a and a first pulse motor 32a for unidirectionally rotatably driving the belt 31a, the belt 31a fixing thereon a pair of carrier bodies 10a, 10a. The carrier bodies 10a, 10a are guided by an endless rail 33 so as to circulatingly move in the work feed position 7, the work area 3 and the work delivery position 8. To each carrier body 10a is swingably pivoted a work holder 11a; and a guide cam plate 35 is disposed along the working line 5 so that work holder 11a stands upright during moving from the work feed position 7 to the work delivery position 8, thereby making its engaging pin 34 engage with an engaging bore 20 of the work 1. Reference numeral 36 designates a cam roller provided at the work holder 11a, 37 designates a return spring, 38a designates a first driving wheel, and 39a designates a first driven wheel.

The first carrier 6a, as above-mentioned, comprises the pair of carrier bodies 10a, 10a and work holders 11a, 11a; and the second carrier 6b comprises the pair of carrier bodies 10b, 10b fixed to a second endless timing bolt 31b and work holders 11b pivoted to the carrier bodies 11b respectively. A second driving means 9b comprises a second endless timing belt 31b and a second pulse motor 32b for unidirectionally rotatably driving the belt 31b. Reference numeral 38b designates a second driving wheel and 39b designates a second driven wheel, which are rotatable independently from the first driving wheel 38a and the first driven wheel 39a.

Thus, the first and second carriers 6a and 6b circulate in one direction without interfering with each other in the work feed position 7, the work area 3 and the work delivery position 8, thereby functioning the same operation as the case of the first embodiment.

Other than those shown in the embodiments, the present invention can be constituted in various modes. For example, three or more sets of the carriers 6a and 6b and carrier driving means 9a and 9b may be provided. Though the moving direction of the work head 2 in the aforesaid embodiments is decided in the direction Y and that of the work 1 in the work area in the direction X, these two are not necessary to cross perpendicularly. Though in the above-mentioned embodiment, the work 1 is held to the carriers 6a and 6b through an engagement of the retractive pin 21 or the engaging pin 34 in the bore 20 of the work 1, other constitution is possible such that the work 1 is held by use of clamping means or the like. Also, the present invention may be applicable to other apparatus, such as a soldering apparatus or a boring apparatus.

As seen from the above, the present invention has the following advantages:

① The loading time of discharging the work finished of operation from the work area and charging therein the next work is reducible largely more than the conventional example, thereby enabling the work efficiency to be improved. Especially, when the number of point of operation per one work is small, the work efficiency will be remarkably improved.

② The work head needs only be moved unidirectionally, the construction can be simplified and to lightweight one in comparison with the conventional work head which necessitates moving in two directions.

List of Reference Numerals in Drawings

| | |
|---|---|
| 1 | work |
| 2 | work head |
| 3 | work area |
| 4 | head driving means |
| 5 | work line |
| 6a, 6b | carrier |
| 7 | work feed position |
| 8 | work delivery position |
| 9a, 9b | carrier driving means |
| 10, 10a, 10b | carrier body |
| 11, 11a, 11b | work holder |
| 12 | part feed unit |
| 13 | discharge side conveyor |
| 14 | feed side conveyor |
| 15 | part |
| 16 | taping cassette apparatus |
| 16a | taping cassette |
| 17 | head body |
| 18 | suction nozzle |
| 19 | guide rail |
| 20 | engaging bore |
| 21 | retractive pin |
| 22 | solenoid |
| 23 | guide plate |
| 24 | rotary shaft |
| 25 | moving unit |
| 26 | fixing unit |
| 27 | swinging lever |
| 28 | guide roller |
| 29a, 29b | cam plate |
| 30a, 30b | cam groove |
| 31a, 31b | endless timing belt |
| 32a, 32b | pulse motor |
| 33 | guide rail |
| 34 | engaging pin |
| 35 | guide cam plate |
| 36 | cam roller |
| 37 | return spring |
| 38a, 38b | driving wheel |
| 39a, 39b | driven wheel |
| 50 | part feed unit |
| 51 | work head |
| 52 | working line |
| 53 | work |
| 54 | work area |
| 55 | positioning means |
| 56 | delivery position |
| 57 | stand-by position |
| 58 | stopper |
| X | direction X |
| Y | direction Y |
| Z | direction Z |
| P, Q | work |
| L | part transportation line |

**Claims**

1. A working apparatus comprising plural carriers (6a,6b) for holding and moving works along a working line (5) from a work feed position (7) to a work station (3) and to a work discharge position (8), and a movable work head (2) for applying predetermined operations at predetermined positions on a work (1) at the work station (3),

characterized by

head driving means (4) for moving said work head (2) in a direction different from the moving direction of the works (1) and positioning said head (2) in its said moving direction for a point of operation at a predetermined position on the work (1) for each operation, and

carrier driving means (9a,9b) for each of said carriers (6a,6b) for moving said carriers (6a,6b) independently of each other along said working line (5) from said work feed position (7) to said work station (3) and to said work discharge position (8), and back to said work feed position, and for positioning each carrier in its said moving direction for a point of operation at a predetermined position on the work at said work station for each operation said carriers (6a,6b) being constituted not to interfere at the time of motion with other ones of said carriers (6a,6b) and said works (1).

2. The apparatus defined in claim 1, characterized in that said carriers (6a,6b) are movable in circulation on an endless path.

3. The apparatus defined in claim 1 or 2, characterized by means for changing the posture of the carriers (6a,6b) during movement back to the work feed position (7) to avoid interference with other carriers (6a,6b) and works (1) being held and moved thereby.

4. The apparatus defined in claim 3, characterized in that said posture-changing means includes a fixed endless cam groove (30a) and a cam follower (28) on each carrier riding in said groove (30a).

5. The apparatus defined by anyone of the preceding claims, characterized in that each carrier driving means includes an endless belt (31a,31b) and a pulse motor (32a,32b) for driving said belt independently of any other driving means.

6. The apparatus defined in claim 1, characterized in that said carriers (6a,6b) are movable in reciprocation along said working line (5).

**Revendications**

1. Dispositif de montage comprenant une multitude de porteurs (6a, 6b) pour contenir et déplacer des pièces le long d'une ligne de montage (5) à partir d'une position d'amenée de pièce (7) vers une station de montage (3) et vers une position d'évacuation des pièces (8), et une tête de montage déplaçable (2) pour appliquer des opérations prédéterminées à des positions prédéterminées sur une pièce (1) à la station de montage (3),

caractérisé par

un moyen d'entraînement de tête (4) pour déplacer la tête de montage (2) dans un sens différent du sens de déplacement des pièces (1) et pour positionner la tête (2) dans son sens de déplacement en un point d'opération à une position prédéterminée sur la pièce (1) pour chaque opération, et

un moyen d'entraînement de porteurs (9a, 9b) pour chacun des porteurs (6a, 6b) pour déplacer les porteurs (6a, 6b) indépendamment les uns des autres le long de la ligne de montage (5) à partir de la position d'amenée de porteurs (7) vers la station de montage (13) et vers la position d'évacuation de pièces (8), et en retour vers la position d'amenée de pièce, et pour positionner chaque porteur dans son sens de déplacement en un point d'opération à une position prédéterminée sur la pièce à la station de montage pour chaque opération, les porteurs (6a, 6b) étant prévus pour ne pas interférer au moment du déplacement avec les autres porteurs (6a, 6b) et les pièces (1).

2. Dispositif selon la revendication 1, caractérisé en ce que les porteurs (6a, 6b) peuvent se déplacer sur un trajet sans fin.

3. Dispositif selon la revendication 1 ou 2, caractérisé par un moyen pour changer la posture des porteurs (6a, 6b) pendant le déplacement en retour vers la position d'amenée de pièce (7) pour éviter l'interférence avec d'autres porteurs (6a, 6b) et les pièces (1) étant maintenues et déplacées par ceux-ci.

4. Dispositif selon la revendication 3, caractérisé en ce que le moyen de changement de posture comporte un chemin de cames circulaire fixe (30a) et une contre came (28) sur chaque porteur circulant dans le chemin (30a).

5. Dispositif selon l'une quelconque des revendications précédentes, caractérisé en ce que chaque moyen d'entraînement de porteur comporte une courroie sans fin (31a, 31b) et un moteur pas à pas (32a, 32b) pour entraîner la courroie indépendamment de tout autre moyen d'entraînement.

6. Dispositif selon la revendication 1, caractérisé en ce que les porteurs (6a, 6b) sont déplaçables en va-et-vient le long de la ligne de montage (5).

**Patentansprüche**

1. Montage- bzw. Bearbeitungsvorrichtung, umfassend eine Mehrzahl von Trägern (6a,6b) zum Halten und Bewegen von Werkstücken entlang einer Montagelinie (5) von einer Werkstückzuführposition (7) zu einer Montagestation (3) und zu einer Werkstückabgabeposition (8), und einen beweglichen Montage- bzw. Bearbeitungskopf (2), um vorbestimmte Arbeitsvorgänge an vorbestimmten Positionen an einem Werkstück (1) an der Montage- bzw. Bearbeitungsstation (3) auszuführen,

       **gekennzeichnet** durch

       eine Kopfantriebseinrichtung (4), um den Montage- bzw. Bearbeitungskopf (2) in einer Richtung zu bewegen, die von der Bewegungsrichtung der Werkstücke (1) verschieden ist, und um den Kopf (2) für jeden Arbeitsvorgang in seiner Bewegungsrichtung für einen Arbeitspunkt an einer vorbestimmten Position an dem Werkstück (1) zu positionieren, und

       eine Trägerantriebseinrichtung (9a,9b) für jeden der Träger (6a,6b) zum Bewegen der Träger (6a,6b) unabhängig voneinander entlang der Montage- bzw. Bearbeitungslinie (5) von der Werkstückzuführposition (7) zu der Montage- bzw. Bearbeitungsstation (3) und zu der Werkstückabgabeposition (8) und zurück zu der Werkstückzuführposition, und zum Positionieren jedes Trägers für jeden Arbeitsvorgang in seiner Bewegungsrichtung für einen Arbeitspunkt an einer vorbestimmten Position an der Werkstückstation, wobei die Träger (6a,6b) so ausgeführt sind, daß sich zur Zeit der Bewegung keine Störung mit anderen der Träger (6a,6b) und mit den Werkstücken (1) ergibt.

2. Vorrichtung nach Anspruch 1, dadurch gekennzeichnet, daß die Träger (6a,6b) auf einem endlosen Weg im Umlauf bewegbar sind.

3. Vorrichtung nach Anspruch 1 oder 2, gekennzeichnet durch eine Einrichtung zum Ändern der Anordnung oder Lage der Träger (6a,6b) während der Bewegung zurück zu der Werkzeugzuführposition (7), um Störung mit anderen Trägern (6a,6b) und Werkstücken (1) zu verhindern, die durch die Träger gehalten sind und bewegt werden.

4. Vorrichtung nach Anspruch 3, dadurch gekennzeichnet, daß die Lageänderungseinrichtung eine ortsfeste endlose Nockennut (30a) und ein Nockennachlaufglied (28) an jedem Träger umfaßt, welches in der Nut (30a) läuft.

5. Vorrichtung nach irgendeinem der vorhergehenden Ansprüche, dadurch gekennzeichnet, daß jede Trägerantriebseinrichtung einen endlosen Riemen (31a,31b) und einen Impulsmotor (32a,32b) zum Antreiben des Riemens unabhängig von irgendeiner anderen Antriebseinrichtung umfaßt.

6. Vorrichtung nach Anspruch 1, dadurch gekennzeichnet, daß die Träger (6a,6b) entlang der Montage- bzw. Bearbeitungslinie (5) hin- und herbewegbar sind.

FIG. 1

FIG. 2

FIG. 3

FIG. 4

FIG. 5

FIG. 6

FIG. 7

FIG. 8

FIG. 9

FIG. 10